# EUROPEAN PATENT SPECIFICATION

(11) **EP 3 553 536 B1**
(45) Date of publication and mention of the grant of the patent: **09.03.2022**
(21) Application number: 18167271.8
(22) Date of filing: 13.04.2018
(51) Int. Cl.: G01R 15/14, G01R 19/25

(54) **COMBINATION OF A SENSOR MODULE AND A FUSE, AND USE OF A SENSOR MODULE IN THE COMBINATION**
KOMBINATION EINES SENSORMODULS UND EINER SICHERUNG, UND VERWENDUNG EINES SENSORMODULS IN DER KOMBINATION
COMBINAISON D'UN MODULE DE CAPTEUR ET UN FUSIBLE ET UTILISATION D'UN MODULE DE CAPTEUR DANS LA COMBINAISON

(43) Date of publication of application: 16.10.2019
(73) Proprietor: Muco Technologies B.V., 1046 AG Amsterdam (NL)
(72) Inventor: LEIPOLDT, Peter, 1046 AG Amsterdam (NL)
(74) Representative: Plaggenborg, Menko Bernard

(56) References cited:
- EP-A1- 3 093 672
- WO-A1-2017/078525
- WO-A1-2017/098021
- US-A1- 2013 024 139
- US-A1- 2017 059 640

## Description

The present invention relates to a combination of a current sensor module for measuring an electric current through an electrical conductor and a fuse according to claim 1, and a use according to claim 2.

It is known in the art to measure properties of an electric current flowing through a conductor, such as the current or the voltage. For this purpose, a sensor or measuring device is placed on the conductor and the measurement is carried out.

Such sensors and measuring devices have the property that a separate sensor or device must be used for measuring the desired properties. A user must also be at the location of the measurement.

A drawback of the fact that one has to check the information personally is that there are many man hours with correspondingly high costs.

One reason for carrying out such a measurement is to check the properties of an electricity grid. Furthermore, it is valuable for the network manager to know what the characteristics of the network are prior to an interruption of the electricity grid. However, only by chance a property of the electric current through a conductor before an interruption can be measured in the manner as known in the art. This is the case, for example, when an incident has occurred the cause of which is unknown. This cause cannot be determined due to a lack of measurement data.

The invention is defined by the independent claims and now aims to provide a combination according to claim 1 and a use according to claim 2, wherein the sensor module is an improved sensor module

The invention also aims to include a sensor module with which an automatic measurement of desired properties can be carried out.

Another object of the invention is to include a sensor module with which a series of measurement data obtained in the past remains available for use, management and processing.

Another object of the invention is to provide a combination of a fuse and a sensor module according to the invention.

In order to obtain at least one of these objectives, the invention relates to a combination of a current sensor module and a fuse according to claim 1. Furthermore, it can transmit measurement data to a receiver which stores the data. This provides the advantage that in case of an incident, it can be checked at any time which properties or characteristics the electric current through the conductor had prior to the incident.

Surprisingly, this provides the advantage that the measurement data are available for later use, management, analysis or processing, so that the user can obtain much more information from the measurement data than originally was possible and the goal for a temporary measurement which was performed by a user on location.

Examples of known current sensor modules are described in WO2017/098021A1, US2017/059640A1, WO2017/078525A1, US2013/024139A1 and EP3093672A1.

It has also been found that the sensor module used in the invention does not require separate energy supply. The current flowing through the conductor is sufficient to supply the sensor, as necessary. Such a synergistic effect is surprising and advantageous.

The invention therefore relates to a combination of a current sensor module, for measuring an electric current through an electrical conductor, and a fuse, the current sensor module comprising a sensor for measuring the current strength of the electrical current flowing through the conductor, wherein the current sensor module further comprises a transmitter configured to transmit current strength data measured by the sensor to a receiver of a data collecting device wherein the current sensor module is adapted for combination with the fuse protecting the electrical conductor against overload, wherein the current sensor module is placed in a housing comprising a through hole through which one terminal extending from the housing of the fuse is inserted, and wherein the current sensor module and the fuse each have their own housing. This current sensor module provides the effect that data of the electric current through the conductor can be measured in a simple manner. As a result, at any time it is not only possible to check what the conditions were at the time of a failure of the fuse, but also to carry out a continuous analysis of the electricity network.

The combination according to the invention is of a standardized size, so that it can easily be used. By use of the sensor module used in the invention in combination with a fuse a simple possibility is obtained to continuously collect data of the electrical current through the conductor. In particular, the total external dimension of the new sensor module and the fuse used, which collectively contains both the sensor and the transmitter and the current-interrupting part serving as a fuse, must be equal to the outer dimension of a fuse according to the state-of-the-art. Hence, in accordance with the combination of the present invention, the one of the terminals being embodied to be received in the through hole to superpose the housing of the current sensor module and the housing of the fuse, wherein the lengths of said terminals extending from the current sensor module housing and the fuse housing, after placement of the current sensor module on the one terminal, are substantially equal.

WO2017/098021A1 teaches a housing incorporating the fuse, a current sensing device, a microprocessor 33 and a communication module. US2017/059640A1 describes a monitoring system. WO 2017/078525 describes a system for monitoring electric current in a network comprising at least one electrical fuse. US2013/024139A1 comprises two electrical connectors for connecting the current sensor to the portion of the electrical system, such that there is a direct, physical connection of the sensor with the electrical system.

According to a further aspect, the invention relates to the use of the current sensor module in the combination according to the present invention for measuring the electric current through the electrical conductor, the current sensor module comprising the sensor for measuring the current strength of the electrical current flowing through the conductor, wherein the current sensor module further comprises the transmitter for transmitting current strength data measured by the sensor to the receiver of the data collecting device, wherein the current sensor module is adapted for combination with the fuse which is designed for protecting the electrical conductor against overload, wherein the current sensor module is placed in the housing comprising the through hole through which the one terminal extending from the housing of the fuse is inserted, wherein the fuse comprises two protruding terminals at opposite sides of the housing of the fuse, one of which terminals being embodied to be received in the through hole wherein the lengths of said terminals extending from the current sensor module housing and the fuse housing, after placement of the current sensor module on the one terminal, are substantially equal.

Suitably, a measurement is made of the current strength through the conductor to obtain an indication of any problems occurring prior to the failure of the fuse. Therefore, the current sensor module comprises a sensor for measuring the current strength. Preferably, the sensor module further comprises a sensor for measuring the temperature.

As mentioned above, the current sensor module further comprises a transmitter for transmitting data measured by the sensor to a receiver of a data collecting device. This allows the measurement data to be transmitted simply and instantaneously to a receiver that stores the data, for example for processing by a user. It is especially advantageous if the sensor module according to the invention also comprises a receiver in connection with carrying out software updates or the like of the electronics in the sensor module used in the invention. This can be a software update for the sensor part, but also for other components that are included in the sensor module.

In this description, in many cases reference will be made to only one transmitter, not only referring to the transmitting part of the sensor module but also to the receiving part. The communication device in the sensor module used in the invention will usually be a transmitter / receiver. However, it is possible to design the sensor module used in the invention with only one transmitter, with which an effective embodiment of the invention is obtained. However, preference is given to a combined transmitter / receiver.

Optionally, a sensor may be present at the current conductors for measuring the voltage in the conductors.

It is especially preferred that the current sensor module comprises a coil for co-operation with electrical alternating current flowing through the conductor for feeding the sensor, the transmitter and optional other electronic components. A capacitor or supercap will also be able to be present as a backup power supply to provide a backup supply, which is particularly important for transmitting measurement data which have been obtained prior to a failure of a fuse, which is meant to be an interruption of the conductor and that had not yet been sent to the receiver.

A suitable application of the sensor module used in the present invention is found in a combination with a blade fuse, the through hole being configured for receiving one blade. This is for example used in distribution boxes in city districts and the like. However, the invention is certainly not limited to a blade fuse.

The invention can also be used, for example, in rail fuses with terminals in the rail as used in distribution boxes in Great Britain.

According to a further aspect it relates to a combination as mentioned before comprising a further combination of the current sensor module and the data collecting device, the data collecting device comprising the receiver for receiving data transmitted by the transmitter of the current sensor module. This simply provides the possibility to collect the characteristics, ie the measured data and properties, to make them available for later processing and consideration.

Preferably, in the combination the data collecting device comprising a receiver for receiving data transmitted by the transmitter of the current sensor module.

The contents of the memory of the data collecting device can suitably be retrieved by a user when the data collecting device comprises a communication device for exchanging data with a user for consideration, storage, analysis or process of the data. The transmitter can be both wireless and wired. The type of wireless transmission is not limiting to the invention. Wifi, bluetooth, Zigbee, GPRS, 3G, 4G, 5G and all other wireless transmission and reception methods are in principle suitable for use in the present invention. There are also several wired types that can be used for exchange of data, for example by means of glass fiber, coax and other wired embodiments.

A practical embodiment provides that the transmitter being part of the communication device of the data collecting device is configured to send the data to a data storage device directly accessible by the user. For example, this may occur when a user sends an order to the data collecting device. The data is then sent to a storage device from which the data can be accessed by the user. For example, the data can then be accessed by multiple users and / or uploaded for consideration and / or processing. The storage device may be a personal hard disk or a server accessible from a personal workplace (for example a cloud server) or the like.

Finally, it is preferred that the data collecting device has an input device and output device for exchanging instructions and information with a user, preferably comprised of at least one of a keyboard and a screen or by connection for at least one of a keyboard and a screen. As a result, a user can directly access the electronic components of the data collecting device and optionally the information stored therein wirelessly. In that case, the data can, for example, be transferred directly to a data carrier of the user.

The invention will be explained in more detail below with reference to a drawing.
FIG. 1 shows a schematic block diagram of an application according to the invention,
FIG. 2 is a perspective view of a combination of a fuse and a sensor module according to the invention,
FIG. 3 is a perspective view of a fuse for use with the sensor module according to the invention, and
FIG. 4 is a perspective view of a sensor module used in the invention.

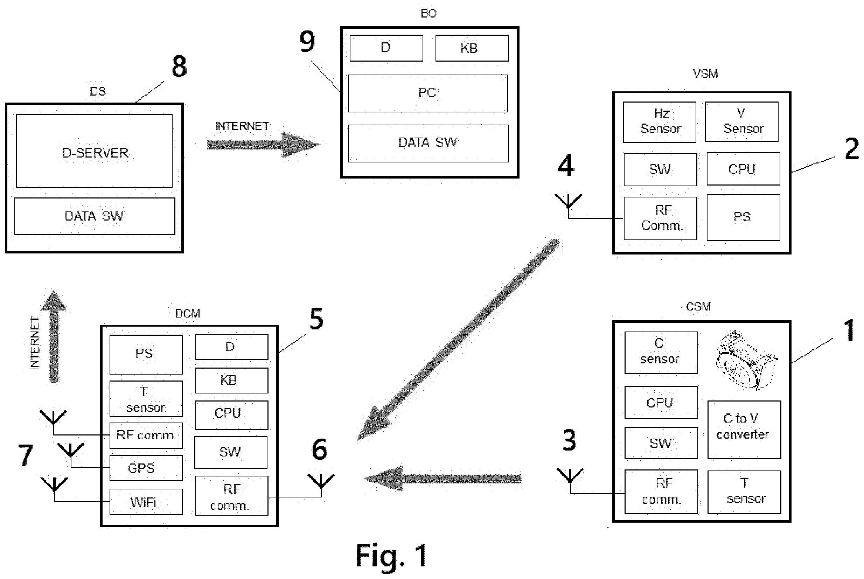

Fig. 1 shows a flow diagram of the application of an embodiment of a sensor module 1 and a voltage sensor module 2 used in the present invention. In addition to a circuit breaker (not shown in the diagram), the diagram comprises the voltage sensor module VSM 2, with a voltage sensor (V sensor) and the current sensor module CSM 1 therein. The current sensor module CSM 1 includes, among other things, an amp sensor, also referred to as current sensor or current strength sensor (C sensor), as well as a temperature sensor (T sensor), as schematically indicated in current sensor module 1. To control the electronics, a processing unit (CPU) is provided, as well as suitable software (SW) for that purpose. A current-to-voltage converter (C to V converter) will also be provided for feeding the electronics. A power source in the form of a supercap (not shown) may also be present for stable feeding of the electronic components. Finally, in each of the current sensor module 1 and the voltage sensor module 2 a combined transmitter / receiver 3, 4 is provided (schematically shown at sensor module CSM 1 and voltage sensor module VSM 2) for transmitting measured characteristics, such as current, temperature and voltage, depending on the sensors present and, respectively, receiving, for example, software updates.

The data measured in the voltage sensor module 2 and current sensor module 1 is transmitted to a receiver 6 of a data collecting device 5. The data collecting device 5 also comprises a CPU and suitable software for storing the data in a memory. The data collecting device 5 can also comprise a temperature sensor to check its condition. In addition, the data collecting device 5 may comprise a keyboard (KB) and a display (D), for inputting data to or extracting data from the data collecting device 5. The data collecting device 5 may comprise its own power supply, for example a mains supply of 230 VAC, as in the figure shown, or its own independent battery to be able to send data and to receive and process instructions in the event of a power failure.

The data collecting device 5 comprises one or more transmitter / receiver 7, the transmitter being suitable for continuously transmitting the received measurement data to a data storage device 8 and / or wherein the receiver is suitable for optionally first receiving instructions from, for example, an end user before sending the data received from the sensors to a data storage device 8. Alternatively, a router may be provided to connect the data collecting device to the internet, for example to provide the transmission of the measurement data to the data storage device 8. The device 8 can be an externally accessible server (for example a cloud server) or a storage disc which is directly accessible to a user.

For this purpose, the data collecting device 5 is provided with a device 7 (for example a wireless or wired transmitter / receiver or a router) which connects the data collecting device 5 to the internet.

The user has a direct connection to the data storage device 8 and can view, process and examine the data from a user position 9 on a computer (PC), with keyboard (KB) and display (D), which runs suitable software (Data SW). The user in the Back Office (BO) can also have a connection to the data collecting device 5 via the internet via a router.

The sensor module used the invention can perform a continuous measurement during, for example, every second or even every millisecond (or even better) and transmit the measured data to the data collecting device 5. It can store the data for a predetermined period, after which the oldest data are overwritten by latest data, or can transfer the data real-time to a server for storage. For example, after detection of power failure in the fuse, by interrupting the current conductor through the fuse, the stored data can be retrieved by the user, after which the data collecting device 5 forwards the data of a specified time-period to the data storage device 8. From there the data can be considered, viewed, analyzed and processed through suitable back office / diagnostic software. In this way, at all times the cause of an interruption can be searched simply and successfully. The measurement data can also be analyzed for other reasons, for example to examine characteristics of power consumption or power production (in particular, but not exclusively, by solar panels).

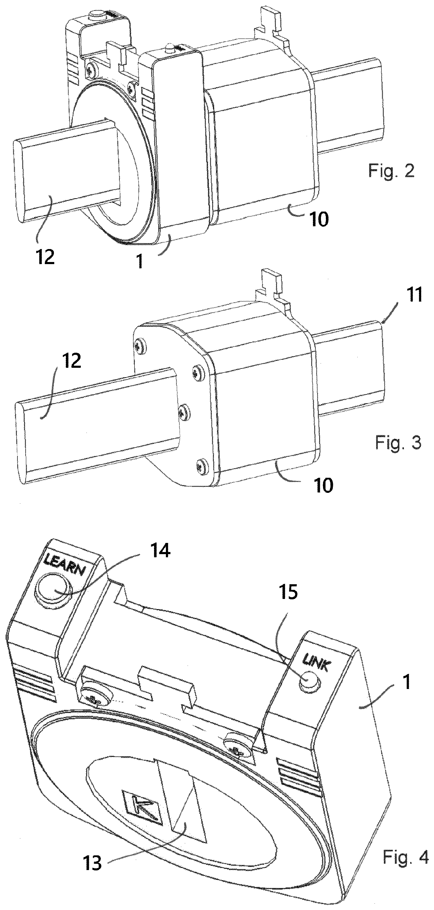

Fig. 2 is a perspective view of a combination of a current sensor module 1 and a fuse 10. The fuse 10 comprises a circuit breaker which can be activated when the current strength is too high, as a result of which the electric current in the electrical conductor is interrupted. The current sensor module 1 includes a current sensor and electronics to measure the current and a memory to store the measured value. The current sensor module 1 also comprises a transmitter / receiver for transmitting the measured values to a data collecting device 5.

In an embodiment not falling under the present invention, the current sensor module 1 and the fuse 10 can optionally be integrated in a single housing. The fuse 10, shown as an example in FIG. 2 and 3, is of the blade fuse type. The current sensor module 1 can be pushed over a connection 12 of the fuse module 10, so that the total size of the combination of the current sensor module 1 and the fuse 10 is identical to that of a conventional fuse. The housing of the fuse module 10, as shown in FIG. 2 and 3, therefore, is smaller than that of a conventional fuse. The lengths of the protruding part of the connections 11 and 12, after placement of the current sensor module on connection 12, are substantially equal.

Fig. 4 is a perspective view of a current sensor module 1 for use in accordance with the invention. The current sensor module 1 has a through hole 13 through which the terminal 12 of the fuse module 10 can be inserted. The current sensor module 1 comprises an energy supply (for example a supply coil) which feeds the electronic components into the sensor module or which charges a capacitor or supercap in the current sensor module for supplying the electronic components.

The current sensor module 1 contains software for controlling the sensor, the transmitter and receiver and any other electronic components. Furthermore, a possibility is provided by means of a manually operated button 14 (indicated by the code "Learn") to connect the sensor to the data collecting device 5. A correct connection with a receiver is indicated by a lighted LED 15 (indicated by the code "Link").

The transmitter / receiver can be equipped for indoor communication, but can also be suitable for outdoor communication. Usually the transmitter / receiver 3, 4, 6 will be suitable for indoor communication and the transmitter / receiver 7 is suitable for outdoor communication.

The invention is not limited to the embodiments described above and shown in the drawing. The invention is only limited by the appended claims.

## Claims

1. A combination of a current sensor module (1), for measuring an electric current through an electrical conductor, and a fuse (10), the current sensor module (1) comprising a sensor for measuring the current strength of the electrical current flowing through the conductor,
wherein the current sensor module (1) further comprises a transmitter (3) configured to transmit current strength data measured by the sensor to a receiver (6) of a data collecting device (5), wherein the current sensor module (1) is adapted for combination with the fuse (10) protecting the electrical conductor against overload, the fuse (10) comprises two protruding terminals (11, 12) at opposite sides of a housing of the fuse (10), wherein the current sensor module (1) is placed in a housing comprising a through hole (13) through which one terminal (12) extending from the housing of the fuse (10) is inserted, and wherein the current sensor module (1) and the fuse (10) each have their own housing,
wherein the one (12) of the terminals (11, 12) being embodied to be received in the through hole (13) to superpose the housing of the current sensor module (1) and the housing of the fuse (10), wherein the lengths of said terminals (11, 12) extending from the current sensor module housing and the fuse housing, after placement of the current sensor module (1) on the one terminal (12), are substantially equal.

2. Use of a current sensor module (1) in a combination according to claim 1 for measuring the electric current through the electrical conductor, the current sensor module (1) comprising the sensor for measuring the current strength of the electrical current flowing through the conductor,
wherein the current sensor module (1) further comprises the transmitter (3) for transmitting current strength data measured by the sensor to the receiver (6) of the data collecting device (5), wherein the current sensor module (1) is adapted for combination with the fuse (10) which is designed for protecting the electrical conductor against overload, wherein the current sensor module (1) is placed in the housing comprising the through hole (13) through which the one terminal (12) extending from the housing of the fuse (10) is inserted,
wherein the fuse (10) comprises two protruding terminals (11, 12), the one (12) of which terminals (11, 12) being embodied to be received in the through hole (13) wherein the lengths of said terminals (11, 12) extending from the current sensor module housing and the fuse housing, after placement of the current sensor module (1) on the one terminal (12), are substantially equal.

3. Use in accordance with claim 2, wherein the current sensor module (1) comprises the sensor for measuring the current strength and a sensor for measuring the temperature.

4. Use in accordance with claim 2, wherein the current sensor module (1) comprises a coil for co-operation with electrical alternating current flowing through the conductor for feeding the sensor, the transmitter (3) and optional other electronic components.

5. Use in accordance with claim 2, wherein the fuse (10) is a blade fuse (10), the through hole (13) being configured for receiving the blade (12) of the blade fuse (10).

6. Use in accordance with one of claims 2-5 comprising a further combination of the current sensor module (1) and the data collecting device (5), the data collecting device (5) comprising the receiver (6) for receiving data transmitted by the transmitter (3) of the current sensor module (1).

7. Use in accordance with claim 6, wherein the data collecting device (5) comprises a memory for storing received data.

8. Use in accordance with claim 6 or 7, wherein the data collecting device (5) comprises a communication device (7) for exchanging data with a user for consideration, storage, analysis or processing of the data.

9. Use in accordance with claim 8, wherein a transmitter (7) being part of the communication device (7) of the data collecting device (5) is configured to send the data to a data storage device (8) directly accessible by the user.

10. Use in accordance with one of claims 6 - 9, wherein the data collecting device (5) has an input device and output device for exchanging instructions and information with a user, preferably comprised of at least one of a keyboard and a screen or by connection for at least one of a keyboard and a screen.

## Patentansprüche

1. Kombination aus einem Stromsensormodul (1) zum Messen eines elektrischen Stroms durch einen elektrischen Leiter und einer Sicherung (10), worin das Stromsensormodul (1) einen Sensor zum Erfassen der Stromstärke des durch den Leiter fließenden elektrischen Stroms umfasst,
worin das Stromsensormodul (1) ferner einen Transmitter (3) umfasst, der ausgestaltet ist, die von dem Sensor erfassten Stromstärkedaten an einen Empfänger (6) einer Datenerfassungseinrichtung (5) zu übertragen,
worin das Stromsensormodul (1) angepasst ist, mit der Sicherung (10), die den elektrischen Leiter gegen Überlast schützt, kombiniert zu werden, worin die Sicherung (10) zwei hervorstehende Anschlüsse (11, 12) an abgewandten Seiten eines Gehäuses der Sicherung (10) aufweist, worin das Stromsensormodul (1) in einem Gehäuse angeordnet ist, das ein Durchgangsloch (13) aufweist, durch das ein Anschluss (12), der sich von dem Gehäuse der Sicherung (10) erstreckt, eingeführt ist, und worin das Stromsensormodul (1) und die Sicherung (10) jeweils ihr eigenes Gehäuse aufweisen,
worin der eine (12) der Anschlüsse (11, 12) ausgestaltet ist, in dem Durchgangsloch (13) aufgenommen zu werden, um das Gehäuse des Stromsensormoduls (1) und das Gehäuse der Sicherung (10) zu überlagern, worin die Längen der Anschlüsse (11, 12), die sich von dem Stromsensormodulgehäuse und dem Sicherungsgehäuse erstrecken, nach dem Anbringen des Stromsensormoduls (1) an dem einen Anschluss (12) im Wesentlichen gleich sind.

2. Verwendung eines Stromsensormoduls (1) in einer Kombination nach Anspruch 1 zur Erfassung des elektrischen Stroms durch den elektrischen Leiter, worin das Stromsensormodul (1) den Sensor zum Erfassen der Stromstärke des durch den Leiter fließenden elektrischen Stroms umfasst,
worin das Stromsensormodul (1) ferner den Transmitter (3) zum Übertragen der vom Sensor erfassten Stromstärkedaten an den Empfänger (6) der Datenerfassungseinrichtung (5) umfasst,
worin das Stromsensormodul (1) angepasst ist, mit der Sicherung (10), die zum Schutz des elektrischen Leiters gegen Überlast ausgelegt ist, kombiniert zu werden, worin das Stromsensormodul (1) in dem Gehäuse angeordnet ist, das das Durchgangsloch (13) aufweist, durch das der eine Anschluss (12), der sich aus dem Gehäuse der Sicherung (10) erstreckt, eingesetzt wird,
worin die Sicherung (10) zwei hervorstehende Anschlüsse (11, 12) aufweist, von denen der eine (12) ausgestaltet ist, in dem Durchgangsloch (13) aufgenommen zu werden, worin die Längen der Anschlüsse (11, 12), die sich von dem Stromsensormodulgehäuse und dem Sicherungsgehäuse erstrecken, nach dem Anbringen des Stromsensormoduls (1) an dem einen Anschluss (12) im Wesentlichen gleich sind.

3. Verwendung nach Anspruch 2, worin das Stromsensormodul (1) den Sensor zum Erfassen der Stromstärke und einen Sensor zum Erfassen der Temperatur umfasst.

4. Verwendung nach Anspruch 2, worin das Stromsensormodul (1) eine Spule zum Zusammenwirken mit dem durch den Leiter fließenden elektrischen Wechselstrom zur Versorgung des Sensors, des Transmitters (3) und wahlweise weiterer elektronischer Komponenten aufweist.

5. Verwendung nach Anspruch 2, worin die Sicherung (10) eine Messersicherung (10) ist und das Durchgangsloch (13) ausgestaltet ist, das Messer (12) der Messersicherung (10) aufzunehmen.

6. Verwendung nach einem der Ansprüche 2 bis 5 mit einer weiteren Kombination aus dem Stromsensormodul (1) und der Datenerfassungseinrichtung (5), worin die Datenerfassungseinrichtung (5) den Empfänger (6) zum Empfang der durch den Transmitter (3) des Stromsensormoduls (1) gesendeten Daten umfasst.

7. Verwendung nach Anspruch 6, worin die Datensammeleinrichtung (5) einen Speicher zum Speichern der empfangenen Daten umfasst.

8. Verwendung nach Anspruch 6 oder 7, worin die Datensammeleinrichtung (5) eine Kommunikationseinrichtung (7) zum Austausch von Daten mit einem Benutzer zur Prüfung, Speicherung, Analyse oder zur Verarbeitung der Daten umfasst.

9. Verwendung nach Anspruch 8, worin ein Transmitter (7), der Teil der Kommunikationseinrichtung (7) der Datensammeleinrichtung (5) ist, ausgestaltet ist, die Daten an eine für den Benutzer direkt zugängliche Datenspeichereinrichtung (8) zu senden.

10. Verwendung nach einem der Ansprüche 6 bis 9, worin die Datensammeleinrichtung (5) eine Eingabe- und Ausgabeeinrichtung zum Austausch von Anweisungen und Informationen mit einem Benutzer aufweist, vorzugsweise bestehend aus mindestens einer Tastatur und einem Bildschirm oder durch Anschluss für mindestens eine Tastatur und einen Bildschirm.

## Revendications

1. - Combinaison d'un module de capteur de courant (1), pour mesurer un courant électrique à travers un conducteur électrique, et d'un fusible (10), le module de capteur de courant (1) comprenant un capteur pour mesurer l'intensité de courant du courant électrique circulant à travers le conducteur,
le module de capteur de courant (1) comprenant en outre un émetteur (3) configuré pour émettre des données d'intensité de courant mesurées par le capteur à un récepteur (6) d'un dispositif de collecte de données (5),
le module de capteur de courant (1) étant conçu pour être combiné au fusible (10) protégeant le conducteur électrique contre une surcharge, le fusible (10) comprenant deux bornes en saillie (11, 12) sur des côtés opposés d'un boîtier du fusible (10), le module de capteur de courant (1) étant placé dans un boîtier comprenant un trou traversant (13) à travers lequel une borne (12) s'étendant depuis le boîtier du fusible (10) est insérée, et le module de capteur de courant (1) et le fusible (10) ayant chacun leur propre boîtier,
l'une (12) des bornes (11, 12) étant conçue pour être reçue dans le trou traversant (13) de façon à superposer le boîtier du module de capteur de courant (1) et le boîtier du fusible (10), et les longueurs desdites bornes (11, 12) s'étendant depuis le boîtier de module de capteur de courant et le boîtier de fusible, après placement du module de capteur de courant (1) sur ladite borne (12), étant sensiblement égales.

2. - Utilisation d'un module de capteur de courant (1) dans une combinaison selon la revendication 1 pour mesurer le courant électrique à travers le conducteur électrique, le module de capteur de courant (1) comprenant le capteur pour mesurer l'intensité de courant du courant électrique circulant à travers le conducteur,
le module de capteur de courant (1) comprenant en outre l'émetteur (3) pour émettre des données d'intensité de courant mesurées par le capteur au récepteur (6) du dispositif de collecte de données (5),
le module de capteur de courant (1) étant conçu pour être combiné au fusible (10) qui est conçu pour protéger le conducteur électrique contre une surcharge, le module de capteur de courant (1) étant placé dans le boîtier comprenant le trou traversant (13) à travers lequel ladite borne (12) s'étendant depuis le boîtier du fusible (10) est insérée,
le fusible (10) comprenant deux bornes en saillie (11, 12), ladite borne (12) desdites bornes (11, 12) étant conçue pour être reçue dans le trou traversant (13), les longueurs desdites bornes (11, 12) s'étendant depuis le boîtier de module de capteur de courant et le boîtier de fusible, après placement du module de capteur de courant (1) sur ladite borne (12), étant sensiblement égales.

3. - Utilisation selon la revendication 2, dans laquelle le module de capteur de courant (1) comprend le capteur pour mesurer l'intensité de courant et un capteur pour mesurer la température.

4. - Utilisation selon la revendication 2, dans laquelle le module de capteur de courant (1) comprend une bobine pour coopérer avec un courant électrique alternatif circulant à travers le conducteur pour alimenter le capteur, l'émetteur (3) et d'autres composants électroniques facultatifs.

5. - Utilisation selon la revendication 2, dans laquelle le fusible (10) est un fusible à lame (10), le trou traversant (13) étant configuré pour recevoir la lame (12) du fusible à lame (10).

6. - Utilisation selon l'une des revendications 2 à 5, comprenant une combinaison supplémentaire du module de capteur de courant (1) et du dispositif de collecte de données (5), le dispositif de collecte de données (5) comprenant le récepteur (6) pour recevoir des données émises par l'émetteur (3) du module de capteur de courant (1).

7. - Utilisation selon la revendication 6, dans laquelle le dispositif de collecte de données (5) comprend une mémoire pour stocker des données reçues.

8. - Utilisation selon la revendication 6 ou 7, dans laquelle le dispositif de collecte de données (5) comprend un dispositif de communication (7) pour échanger des données avec un utilisateur pour la prise en compte, le stockage, l'analyse ou le traitement des données.

9. - Utilisation selon la revendication 8, dans laquelle un émetteur (7) faisant partie du dispositif de communication (7) du dispositif de collecte de données (5) est configuré pour envoyer les données à un dispositif de stockage de données (8) directement accessible par l'utilisateur.

10. - Utilisation selon l'une des revendications 6 à 9, dans laquelle le dispositif de collecte de données (5) a un dispositif d'entrée et un dispositif de sortie pour échanger des instructions et des informations avec un utilisateur, composés de préférence d'au moins l'un parmi un clavier et un écran ou par connexion pour au moins l'un parmi un clavier et un écran.
